# EUROPEAN PATENT APPLICATION

(11) **EP 4 492 175 A1**
(43) Date of publication of application: **15.01.2025**
(21) Application number: 23184949.8
(22) Date of filing: 12.07.2023
(51) Int. Cl.: G05B 23/02, G01R 31/00

(54) **COMPUTER-IMPLEMENTED METHOD FOR PROVIDING DATA INDICATIVE OF AN INTERMITTENT FAILURE FOR A VEHICLE**

(71) Applicant: Volvo Car Corporation, 405 31 Göteborg (SE)
(72) Inventor: LEUCHOVIUS, Nicklas, 40531 Göteborg (SE); HELIN, Bo, 40531 Göteborg (SE)
(74) Representative: Maiwald GmbH

(57) **Abstract**

The disclosure relates to a computer-implemented method (100) for providing data indicative of an intermittent failure for a vehicle, comprising: providing (110) failure data of the vehicle; providing (120) counter data, wherein counter data is provided for each provided failure data; providing (130) data indicative of an intermittent failure at least based on the counter data.

## Description

### TECHNICAL FIELD

The present disclosure relates to a computer-implemented method for providing data indicative of an intermittent failure for a vehicle, a system for providing data indicative of an intermittent failure for a vehicle, a vehicle with a system for providing data indicative of an intermittent failure for a vehicle and/or a use of a decision pattern configured to evaluate failure data.

### BACKGROUND ART

In vehicles, different types of failures may occur and be provided as test failure data to the driver or a service technician, who may read a test failure data storage to identify the problem associated with the failure and repair the vehicle, if needed. One type of a failure is a consistent failure, which may be consistently registered, e.g., at every test cycle of a system of the vehicle. Another type of a failure may be referred to as an intermittent failure. Such failure is not consistent. It may be inconsistently registered, e.g., at every few, specifically a random number of, test cycles of a system of the vehicles. An intermittent failure may be difficult to reproduce, hence it's difficult to resolve the vehicle issue on which intermittent failures are based. In particular, the lack of reproducibility of intermittent failures may be due to the failures being time dependent, the failures being based on complex interaction of system components with one another, bad diagnostic and/or logging.

### SUMMARY

In the view of the above, it is an object of the present disclosure to reliably provide intermittent failure data for a vehicle.

The problem is at least partially solved or alleviated by the subject matter of the independent claims of the present disclosure, whereby further examples are incorporated in the dependent claims.

According to a first aspect, a computer-implemented method for providing data indicative of intermittent failure for a vehicle is disclosed, comprising:
providing failure data of the vehicle;
providing counter data, wherein counter data is provided for each provided failure data;
providing intermittent failure data at least based on the counter data.

The at least one failure data may be provided by a preconfigured service of an ECU (electronic control unit) of the vehicle and/or by a control data configured service of the ECU. Furthermore, the preconfigured service and/or the control data configured service may be configured to obtain information of faults that occur in the vehicle and/or of faults that have occurred in the vehicle.

The at least one failure data may comprise, for example, information about failures or malfunctions of electronic and/or mechanical components of the vehicle. Thereby, the electronic and/or mechanical components of the vehicle may comprise, for example, control units as ECUs of the vehicle, moving elements such as the suspension of the vehicle, etc.

The failure data may comprise failure values which, for example, comprise numbers and/or alphabetic letters. Furthermore, these numbers and/or alphabetic letters may be composed into a sequence of numbers and letters based on the failure.

The failure data may be test failure data. This means that the failure data may relate to one or more tests of the vehicle. By means of one or more tests, systems, which may be or comprise the above mentioned electronic and/or mechanical components, may be tested for failures or, in other words, faults.

The counter data may be configured to count at least the occurrence of failures, wherein further the occurrence of separate failures may be detected. It may be possible that a non-occurrence of faults is counted by means of the counter data, e.g., for predefined time intervals. For example, for every predefined time interval, e.g., in seconds, minutes, hours or days, in which a fault does not occur, the counter may count up. Such counter data may serve as basis for providing the data indicative of an intermittent failure.

For example, the disclosed method may be configured to use the counter data to determine values like an average error value, maximum error value, minimum error value, systematic deviations, random deviations, and/or error limits. Further, based on the counter data and/or the determined values of the counter the method may be configured to determine the data indicative of an intermittent failure, whereby the data indicative of an intermittent failure may comprise absolute and/or percentage data values which are indicating whether a failure is intermittent or not. Accordingly, by providing and utilizing the counter data, in particular using the values like described above, an indication of whether the failure is intermittent or not may be provided with high reliability.

Furthermore, the counter values, the determined values of the counter values and/or the data values of the data indicative of an intermittent failure may be used to determine whether a failure is intermittent and/or whether it occurs on a regular basis. Further, statistical methods may be used in order to identify a failure in an improved manner as an intermittent failure. Further, threshold values may be used, for example, which are compared with the data values, in order to be able to recognize a failure as an intermittent failure.

Furthermore, the data indicative of an intermittent failure may comprise a first indicator based on the data values configured to at least indicate whether a failure is intermittent or a failure is not intermittent. Alternatively, or complementarily, the data indicative of an intermittent failure may comprise a second indicator based on the data values configured to at least indicate whether a failure is a ghost failure or, in other words, misdetection.

The data indicative of an intermittent failure may for example be provided to the vehicle, a control unit of the vehicle, a transmitting and/or receiving unit of the vehicle, and/or a transmitting and/or receiving service of a computer unit of the vehicle.
Thus, with the disclosed method, it may be possible to evaluate which failures are intermittent failures, so that it may be possible to search more specifically for the failures that are not intermittent during a service of the vehicle. It may be possible to identify ghost failures and exclude them for a possible repair of the vehicle and/or from a planned repair of the vehicle.

Knowing that a failure occurs intermittently may also direct a service professional to infrequent true failures where more information is needed about when the failure occurs in order to reproduce and find it. Knowing this may therefore guide the service professional to look for this information rather than trying to find the failure if this is not possible. Loggers may be added to the vehicle or system. Furthermore, snapshots of data may be displayed.

In an example, the at least one failure data may be based on at least one test cycle of the vehicle.

For example, the vehicle may perform test cycles and/or be configured by the control data to perform test cycles. The test cycles may comprise predefined test procedures which test the function of selected systems or components of the vehicle. The test cycles may occur at predefined time intervals.

The test cycles may comprise, for example, a warm-up test cycle of the vehicle, a braking test cycle of the vehicle, a continuous test vehicle, and/or a turn-off test cycle of the vehicle.

Therefore, the counter data may for example refer to errors occurring during a test cycle of the vehicle.

In an example, the at least one failure data may comprise pass values and/or failure values of occurred failures based on the failure data. Accordingly, the failure data may comprise the occurred failures, which may be defined by the pass and/or failure values.

The failure values may for example indicate the occurrence of failures of the vehicle. In addition, the failure values may indicate the occurrence of failures of the vehicle during the test cycles. The failure values may for example represent a failure of a unit of the vehicle during test cycles.

The pass values may indicate whether a failure of the vehicle does not occur. In addition, the pass values may indicate whether a failure of the vehicle does not occur during the test cycles. The pass values may for example represent whether a unit of the vehicle does not return a failure during the test cycles.

In addition, the at least one failure data may also be provided after the test cycle has been performed, whereby the at least one failure data may comprise pass values and/or failure values for each failure that did not occur and/or each failure that did occur.

In an example, the counter data may comprise pass counter values and/or failure counter values, which may be configured to be incremented based on the failure data.

The counter data may be incremented in case of multiple occurrence of a similar and/or an identical failure of the vehicle. In addition, the counter data may be incremented if the similar and/or identical failure occurs within several cycles of the test cycles.

Furthermore, in case of multiple occurrence of the same/identical failure within the several cycles, the failure counter values may be increased based on the failure values. Further, in case a failure of the vehicle does not occur within the several cycles, the pass counter values may be increased based on the pass values.

In addition, the intermittent failure data may be based on, for example, a calculation of the counter data.

In an example, the at least one failure data may comprise diagnostic trouble codes of occurred failures.

The diagnostic fault codes (DTC) may for example comprise predefined identifiers.The identifiers may be configured such that failures of the vehicle, in particular of units, components and/or systems of the vehicle, may be identified, e.g., by association of different failures with different identifiers.

In an example, the data indicative of the intermittent failure may further be based on retrieved log data of the vehicle.

The log data may comprise information about the vehicle. Thus, intermittent failure data may be improved by using information regarding the vehicle in addition to counter data, allowing increased accuracy in determining whether a failure is intermittent.

In an example, the log data may at least comprise information about a usage condition of the vehicle.

The usage condition may comprise information regarding operating conditions of the vehicle and/or operating conditions of units, components or systems of the vehicle, in particular of one or more ECUs of the vehicles.

In this regard, the respective test cycles may be performed at different conditions of use of the vehicle.

In an example, the data indicative of the intermittent failure is based on at least one decision pattern.

The intermittent failure data may be used to calculate a failure rate and, based on the failure rate, to evaluate whether a repair of the vehicle and/or a part of the vehicle is necessary.

In addition, the decision pattern may be used to identify and/or categorize a failure, for example, whereby a failure may be categorized as intermittent, permanent, and/or to be fixed.

The decision pattern may be configured in such a way that it comprises different decision steps or decision levels to categorize a failure. Furthermore, test cycles may be started based on the decision pattern.

In an example, the decision pattern may comprise threshold values, which may be predefined.

For example, the threshold values may be based on mathematical functions and may comprise different thresholds, whereby different thresholds may be given for different failures. In this respect, the threshold values based on mathematical functions may be configured to determine whether a failure is intermittent or not.

Furthermore, the value of the threshold value being used may be based on a mathematical function configured to optimally amend the threshold value with respect to the detection of an intermittent failure. For example, the mathematical function may be used to amend the threshold value over the period of use in order to enable improved detection.

In an example, the failure data may be provided by a diagnostic service of the vehicle.

The diagnostic service may comprise a unified diagnostic service (UDS).

In an example, the method may further comprise providing of control data for the vehicle to configure the vehicle to provide the failure data.

The control data may be configured to modify a diagnostic kernel of an electronic control unit (ECU) of the vehicle. Thereby, the control data may for example configure the vehicle and/or the control unit in such a way that the vehicle and/or the control unit may provide the at least one test failure data.

A further aspect of the present disclosure relates to a system for providing intermittent failure data for a vehicle, comprising:
a first providing unit for providing failure data of the vehicle;
a second providing unit for providing counter data, wherein counter data is provided for each provided failure data;
a third providing unit for providing data indicative of an intermittent failure at least based on the counter data.

A further aspect of the present disclosure relates to a computer program element with instructions, which, when executed on a computing device of a computing environment, is configured to carry out the steps of the disclosed method, in particular in the disclosed system.

A further aspect of the present disclosure relates to a vehicle with the disclosed system for providing data indicative of an intermittent failure for a vehicle.

### BRIEF DESCRIPTION OF DRAWINGS

In the following, the disclosure is described exemplarily with reference to the enclosed figures, in which:
- Fig. 1: is a schematic illustration of an overview of an implementation of the disclosed system;
- Fig. 2: is an example of a diagram of the disclosed computer-implemented method;
- Fig. 3: is a schematic illustration of a first exemplary process for providing intermittent failure data which is based on counter data of test cycles of a vehicle;
- Fig. 4: is a schematic illustration of a second exemplary process for providing intermittent failure data which is based on counter data of test cycles of a vehicle;
- Fig. 5: is a schematic illustration of a third exemplary process for providing intermittent failure data which is based on counter data of test cycles of a vehicle; and
- Fig. 6: is an exemplary illustration of a decision pattern used of the disclosed method.

Notably, the figures are merely schematic representations and serve only to illustrate examples of the present disclosure. Identical or equivalent elements are in principle provided with the same reference signs.

### DETAILED DESCRIPTION

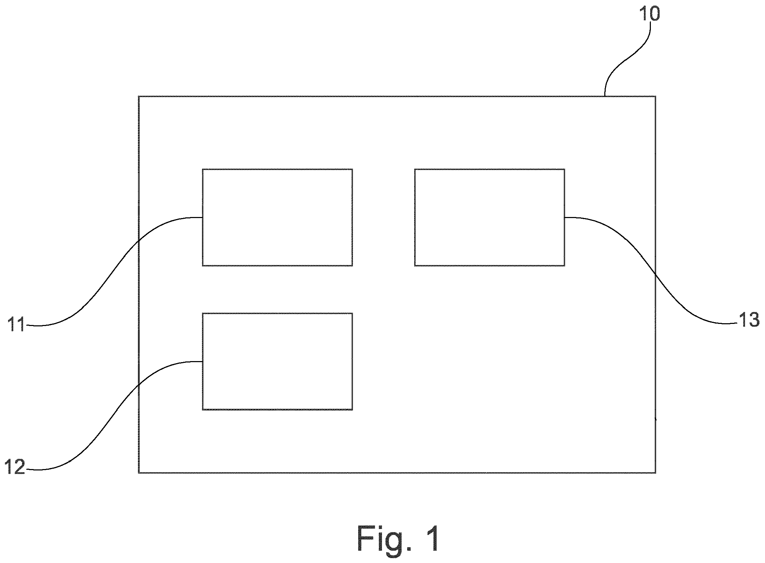

Fig. 1 shows a schematic illustration of an overview of an implementation of the disclosed system 10 for providing control data for controlling a vehicle, comprising: a first providing unit 11 for providing control data for the vehicle to configure the vehicle to provide at least test failure data of the vehicle; a second providing unit 12 for providing counter data if test failure data is received, whereby counter data is provided for each specified failure occurred; a third providing unit 13 for providing intermittent failure data at least based on the counter data.

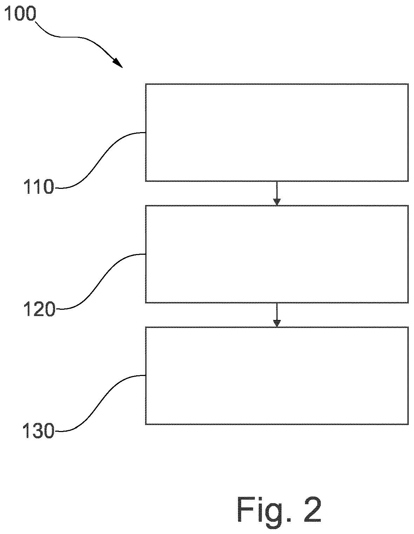

Fig. 2 shows an example of a diagram of the disclosed computer-implemented method 100 for providing intermittent failure data for a vehicle, comprising: providing 110 control data for the vehicle to configure the vehicle to provide at least one test failure data of the vehicle; providing 120 counter data if the at least one test failure data is received, whereby counter data is provided for each of the at least one failure data received; providing 130 intermittent failure data at least based on the counter data.

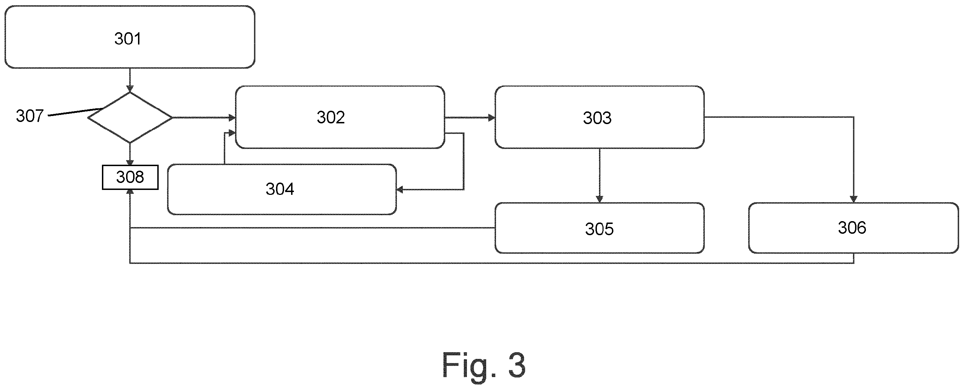

Fig. 3 shows a schematic illustration of a first exemplary process for providing intermittent failure data which is based on counter data of test cycles of a vehicle, whereby the first exemplary process is used a diagnostic service of the vehicle, whereby the disclosed system of Fig. 1 is implemented in the vehicle as an on-board and/or off-board system to check the vehicle status. Moreover, the disclosed system has access to the vehicle parameters and, if used as off-board system, a connection to the vehicle.

Thereby, if a test cycle was performed, for example according to warm-up-cycle (WUC) conditions, counter data are intended to be generated for specified failures of the vehicle in the test cycle, for example DTC, and a pass counter value are intended to be generated and/or increased for all non-resolved failures with respect to the subsequent process, and a failure counter value are intended to be generated and/or increased for all resolved failures with respect to the subsequent process.

Here, in particular, units of the vehicle are determined that are intended to be tested, so that test cycles may be used in which at least some test scenarios are tested to determine specified failures.

In a first step 301 of the first exemplary process, the vehicle and/or the system was used in such a way that at least most of the usage situations that may cause an intermittent failure were met. For example, such a usage situation may be an on-board-diagnose-2 warm-up cycle (OBDII WUC).

Accordingly, the failures that have occurred and/or the failures that have not occurred may be read out. Furthermore, for example, previously detected failures with service 19 03 and/or service 19 02, for example, are also read out. For example, a list of all previously detected failures and ECU address of the previously detected failures may also be generated. Subsequently, the procedure proceeds to a first determination 307 of the first exemplary process.

The service 19 02 may configure the disclosed system for retrieving a list of failures data and/or failure code data like DTC, which satisfy a defined status mask by the disclosed system which allows the disclosed system to request a unit of the vehicle to report all DTCs that comprise the status "testFailed" and/or "confirmed" and/or "etc.".

The service 19 03 may configure the disclosed system for retrieving failure data and/or failure code data like DTC snapshot record identification information for all captured snapshots records by sending a request for this service. Thereby, a unit of the vehicle may return a list of DTC snapshot record identification information for all stored DTC snapshot records. Each item the unit of the vehicle places in the response message for a single DTC snapshot record may contain a DTC record information and/or the DTC snapshot record number. In case multiple DTC snapshot records are stored for a single DTC then the server may place one item in the response for each occurrence, using a different DTC snapshot record number for each occurrence.

In the first determination 307, it is checked whether the specified failures have occurred and/or whether the list of all previously detected failures comprises failures. If the determination detects a failure, it proceeds to a second step 302 of the first exemplary process. If the determination does not detect a failure, it proceeds to the eighth step 308 of the first exemplary process.

In the second step 302, counter data for each specified failure is updated, whereby a failure counter value and/or the pass counter value are generated in the counter data. Furthermore, it is checked, for example with a first test bit of the diagnostic service, whether a specified failure of the specified failures was tested during a test cycle. If the specified failure was tested, it proceeds to a third step 303 of the first exemplary process. If the specified failure was not tested, it proceeds to a fourth step 304 of the first exemplary process.

In the third step 303, it is determined, for example with a second bit of the diagnostic service, whether a specified failure of the specified failures occurred. If a specified failure of the specified failures occurred, it proceeds to a fifth step 305 of first the exemplary process. If a specified failure of the specified failures did not occur, it proceeds to a sixth step 306 of the first exemplary process.

In the fourth step 304, specified failure of the specified failures that were not tested in a respective test cycle are tested. The specified failure may be tested in a timed cycle, which for example has a cycle time of 5 minutes. Further, testing in the timed cycle may continue until the condition for restarting the test cycle is met. Subsequently, the procedure proceeds to the second step 302 after the condition for restarting the test cycle is met.

In the fifth step 305, the test failure counter of a specified failure of the specified failures is incremented based on the tests performed that have resulted in a failure value of the specified failure. Subsequently, the procedure proceeds to an eighth step 308 of the first exemplary process.

In the sixth step 306, the test pass counter of a specified failure of the specified failures is incremented based on the tests performed that have resulted in a pass value of the specified failure. Subsequently, the procedure proceeds to the eighth step 308.

The process ends with the eighth step 308, whereby it is performed again for example in by an external trigger and/or by means of a timer.

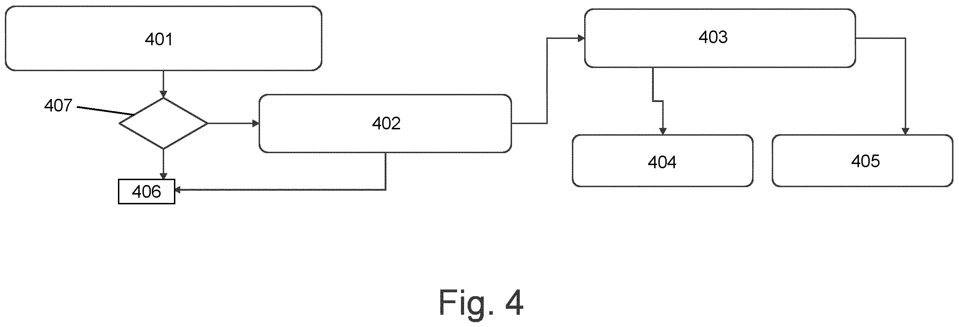

Fig. 4 shows a schematic illustration of a second exemplary process for providing intermittent failure data which is based on counter data of test cycles of a vehicle, whereby the second exemplary process is based on a modification of a diagnostic kernel of the vehicle. Thereby, an ECU of the vehicle count test cycles with passing condition and test cycles with failing condition. Moreover, the diagnostic kernel has access to determined driving conditions used to specify a test cycle.

In a first step 401 of the second exemplary process, the test cycle is ended by the diagnostic kernel. Subsequently, the procedure proceeds to a first determination 407 of the second exemplary process.

In the first determination 407, it is determined whether the test cycle fulfill conditions to define a driving cycle at the end of the test cycle, whereby for example WUC conditions have to be met. If the determination detects that the conditions are fulfilled, it proceeds to a second step 402 of the second exemplary process. If the determination detects that the conditions are not fulfilled, it proceeds to the sixth step 406 of the second exemplary process.

In the second step 402, for each failure saved in a failure memory of the vehicle it is checked whether a failure test was completed, for example with a bit of a diagnostic service of the vehicle.

The failure memory may for example be a memory of an ECU of the vehicle, which is configured to save failures/DTC, whereby the failures/DTC have been detected as a threshold and/or a failed test for a failure.

If a test of a specified failure of each failures saved is completed, it proceeds for this failure to a third step 403 of the second exemplary process. If a test of the specified failure is not completed, it proceeds for this failure to a sixth step 406.

In the third step 403, counter data for the specified failure is updated, whereby a failure counter value and/or the pass counter value are generated in the counter data. If a test passed for the specified failure, it proceeds to a fourth step 404 of the second exemplary process. If the test failed, it proceeds to a fifth step 405 of the second exemplary process.

In the fourth step 404, the pass counter value for the specified failure is increased.

In the fifth step 405, the failure counter value for the specified failure is increased.

The process ends with the sixth step 406, whereby it is performed again for example by an external trigger and/or by means of a timer.

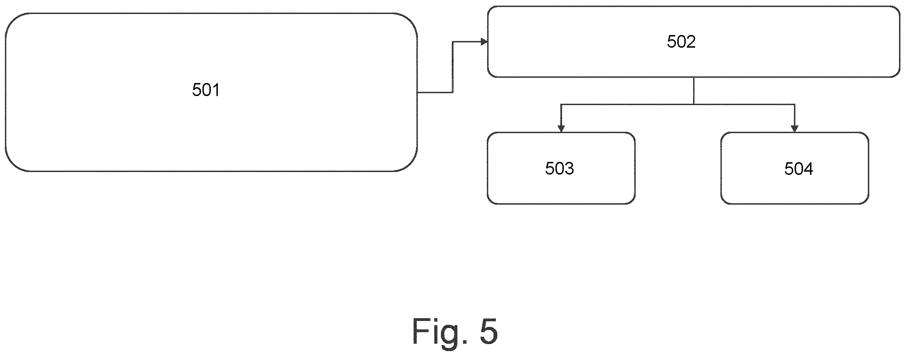

Fig. 5 shows a schematic illustration of a third exemplary process for providing intermittent failure data which is based on counter data of test cycles of a vehicle, whereby a failure monitor of the vehicle is logging failure data and the failure data is provided by the vehicle.

In a first step 501 of the third exemplary process, flow data of the vehicle and/or data of failures is logged in the failure monitor, whereby a logging of driving conditions and/or of a test cycle is done after a first failure occurs. Hereby, the flow data and/or data of failures comprises information when a defined driving condition is fulfilled, when the failure monitor and/or the driving condition is restarted a new operation cycle of the vehicle, information if a failure occured on a test cycle, information whether a test passed for a failure that occurred before/previously and/or information of not completed tests for a unit/part of the vehicle.

In the following, the process continues with a second step 502 of the third exemplary process.

In the second step 502, the failure data is provided and evaluated using the disclosed method to determine intermittent failures. In the following, the process continues with a third step 503 of the third exemplary process and a fourth step 504 of the third exemplary process.

In the third step 503, a number of failed test cycles is calculated based on the failure data.

In the fourth step 504, a number of pass test cycles is calculated based on the failure data.

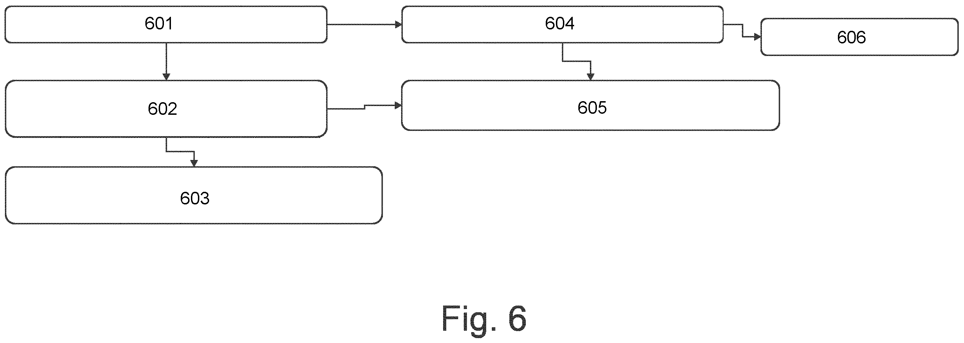

Fig. 6 shows an exemplary illustration of a decision pattern used in the disclosed method, whereby the decision pattern is configured to determine if a failure is intermittent and a repair is required.

In a first step 601 of the decision pattern, a determination is made as to whether a passed test counter value of a failure has exceeded a defined value, whereby this defined value may be, for example, 10, 20 and/or 100. If the passed test counter value is above the defined value, it proceeds to a second step 602 of the decision pattern. If the passed test counter value is below the defined value, it proceeds to a fourth step 604 of the decision pattern.

In the second step 602, a determination whether a ratio of a failure test counter value of the failure to the passed test counter value is within a defined range, whereby the defined range may for example be between 0.01 and 1. If the ratio is below the defined range, it proceeds to a third step 603 of the decision pattern. If the ratio is above the defined range, it proceeds to a fifth step 605 of the decision pattern.

In the third step 603, the failure is identified as an intermittent failure, whereby for example a repair is not recommended if this failure may not lead to major malfunctions of the vehicle.

In the fourth step 604, an estimation is made on the basis of the failure test counter value whether the failure is intermittent, whereby the failure test counter value is compared to a predefined value, whereby this predefined value may be, for example, 5, 10 and/or 100. If the failure test counter value is above the predefined value, it proceeds to a fifth step 605. If the failure test counter value is below the predefined value, it proceeds to a sixth step 606 of the decision pattern.

In the fifth step 605, the failure is identified as a failure to be fixed. In addition, further steps may be added for more accurate identification. These further steps may provide information weather a failure is permanent or possible to reproduce fairly frequent, and failures that need extra attention or should be ignored if they not lead to major malfunctions of the vehicle.

In the sixth step 606, it is determined that further test cycles and/or drive cycles are required to identify the failure.

Other variations to the disclosed examples may be understood and effected by those skilled in the art in practicing the claimed subject matter, from the study of the figures, the disclosure, and the appended claims. In particular, respective parts/functions of the respective example described above may also be combined with each other. In particular, the present disclosure is not limited to specific modules, vehicle functions, user interfaces, user interface areas/fields and/or communication methods. In the claims, the word "comprising" does not exclude other elements or steps and the indefinite article "a" or "an" does not exclude a plurality. The mere fact that certain measures are recited in mutually different dependent claims does not indicate that a combination of these measures may not be used to advantage. Any reference signs in the claims should not be construed as limiting the scope of the claims.

### LIST OF REFERENCE SIGNS

- 10: system for providing intermittent failure data
- 11: first providing unit
- 12: second providing unit
- 13: third providing unit

- 100: method for providing intermittent failure data
- 110: providing control data
- 120: providing counter data
- 130: providing intermittent failure data
- 301: first step of the first exemplary process
- 302: second step of the first exemplary process
- 303: third step of the first exemplary process
- 304: fourth step of the first exemplary process
- 305: fifth step of the first exemplary process
- 306: sixth step of the first exemplary process
- 307: first determination of the first exemplary process
- 308: eighth step of the first exemplary process
- 401: first step of the second exemplary process
- 402: second step of the second exemplary process
- 403: third step of the second exemplary process
- 404: fourth step of the second exemplary process
- 405: fifth step of the second exemplary process
- 406: sixth step of of the second exemplary process
- 407: first determination of the second exemplary process
- 501: first step of the third exemplary process
- 502: second step of the third exemplary process
- 503: third step of the third exemplary process
- 504: fourth step of the third exemplary process
- 601: first step of the decision pattern
- 602: second step of the decision pattern
- 603: third step of the decision pattern
- 604: fourth step of the decision pattern
- 605: fifth step of the decision pattern
- 606: sixth step of the decision pattern

## Claims

1. A computer-implemented method (100) for providing data indicative of an intermittent failure for a vehicle, comprising:
providing (110) failure data of the vehicle;
providing (120) counter data , wherein counter data is provided for each provided failure data;
providing (130) data indicative of an intermittent failure at least based on the counter data.

2. The method (100) according to claim 1, wherein the at least one failure data is based on at least one test cycle of the vehicle.

3. The method (100) according to claim 1 or claim 2, wherein the at least one failure data comprises pass values and/or failure values of occurred failuresbased on the failure data.

4. The method (100) according to any one of the preceding claims, wherein the counter data comprises pass counter values and/or failure counter values, which are configured to be incremented based on the failure data.

5. The method (100) according to any one of the preceding claims, wherein the failure data comprises diagnostic trouble codes of occurred failures.

6. The method (100) according to any one of the preceding claims, wherein the data indicative of the intermittent failure is further based on retrieved log data of the vehicle.

7. The method (100) according to claim 6, wherein the log data at least comprises information about a usage condition of the vehicle.

8. The method (100) according to any one of the preceding claims, wherein the data indicative of the intermittent failure data is based on at least one decision pattern.

9. The method (100) according to claim 8, wherein the decision pattern comprises threshold values.

10. The method (100) according to any one of the preceding claims, wherein the failure data is provided by a diagnostic service of the vehicle.

11. The method (100) according to any one of preceding claims, wherein the method further comprises providing control data for the vehicle to configure the vehicle to provide the test failure data.

12. A system for providing data indicative of an intermittent failure for a vehicle, comprising:
a first providing unit (11) for providing failure data of the vehicle;
a second providing unit (12) for providing counter data, wherein counter data is provided for each provided failure data;
a third providing unit (13) for providing data indicative of an intermittent failure at least based on the counter data.

13. A computer program element with instructions, which, when executed on a computing device of a computing environment, is configured to carry out the steps of the method (100) according to any one of the claims 1 to 11.

14. A vehicle with a system for providing data indicative of an intermittent failure for a vehicle according to claim 12.

## Amended claims

### Amended claims in accordance with Rule 137(2) EPC.

1. A computer-implemented method (100) for providing data indicative of an intermittent failure for a vehicle, comprising:
providing (110) failure data of the vehicle, wherein the failure data comprises pass values and/or failure values of occurred failures based on the failure data;
providing (120) counter data, wherein counter data is provided for each provided failure data, wherein the counter data comprises pass counter values and/or failure counter values, which are configured to be incremented based on the failure data;
providing (130) data indicative of an intermittent failure at least based on the counter data, wherein the data indicative of the intermittent failure data is based on at least one decision pattern, wherein the decision pattern comprises threshold values, wherein the threshold values are based on mathematical functions and configured to determine whether a failure is intermittent or not, and wherein different thresholds are given for different failures.

2. The method (100) according to claim 1, wherein the at least one failure data is based on at least one test cycle of the vehicle.

3. The method (100) according to any one of the preceding claims, wherein the failure data comprises diagnostic trouble codes of occurred failures.

4. The method (100) according to any one of the preceding claims, wherein the data indicative of the intermittent failure is further based on retrieved log data of the vehicle.

5. The method (100) according to claim 4, wherein the log data at least comprises information about a usage condition of the vehicle.The method (100) according to any one of the preceding claims, wherein the failure data is provided by a diagnostic service of the vehicle.

6. The method (100) according to any one of preceding claims, wherein the method further comprises providing control data for the vehicle to configure the vehicle to provide the test failure data.

7. A system for providing data indicative of an intermittent failure for a vehicle, comprising:
a first providing unit (11) for providing failure data of the vehicle, wherein the failure data comprises pass values and/or failure values of occurred failures based on the failure data;
a second providing unit (12) for providing counter data, wherein counter data is provided for each provided failure data, wherein the counter data comprises pass counter values and/or failure counter values, which are configured to be incremented based on the failure data;
a third providing unit (13) for providing data indicative of an intermittent failure at least based on the counter data, wherein the data indicative of the intermittent failure data is based on at least one decision pattern, wherein the decision pattern comprises threshold values, wherein the threshold values are based on mathematical functions and configured to determine whether a failure is intermittent or not, and wherein different threshold values are given for different failures.

8. A computer program element with instructions, which, when executed on a computing device of a computing environment, is configured to carry out the steps of the method (100) according to any one of the claims 1 to 6.

9. A vehicle with a system for providing data indicative of an intermittent failure for a vehicle according to claim 7.
